# EUROPEAN PATENT SPECIFICATION

(11) **EP 0 356 062 B1**
(45) Date of publication and mention of the grant of the patent: **12.10.1994**
(21) Application number: 89308036.6
(22) Date of filing: 08.08.1989
(51) Int. Cl.: H01L 29/08, H01L 29/78, H01L 29/10

(54) **MIS device**
MIS-Bauelement
Dispositif MIS

(30) Priority: 18.08.1988 JP 205529/88; 18.08.1988 JP 205530/88; 18.08.1988 JP 205531/88; 19.05.1989 JP 125854/89
(43) Date of publication of application: 28.02.1990
(73) Proprietor: SEIKO EPSON CORPORATION, Shinjuku-ku Tokyo (JP)
(72) Inventor: Fujisawa, Akira, Suwa-shi Nagano-ken (JP); Takenaka, Kazuhiro, Suwa-shi Nagano-ken (JP)
(74) Representative: Sturt, Clifford Mark

(56) References cited:
- EP-A- 0 267 768
- DE-A- 3 408 285
- PATENT ABSTRACTS OF JAPAN, vol. 9, no. 274 (E-354)(1997), 31 October 1985 ; & JP-A-60 117 674
- PATENT ABSTRACTS OF JAPAN, vol. 10, no. 259 (E-434)(2315), 4 September 1986 ; & JP-A-61 87 374
- PATENT ABSTRACTS OF JAPAN, vol. 6, no. 189 (E-133)(1067), 28 September 1982 ; & JP-A-57 103 356
- PATENT ABSTRACTS OF JAPAN, vol. 7, no. 115 (E-176)(1260), 19 May 1983 ; & JP-A-58 34 958

## Description

This invention relates to a semi-conductor device.

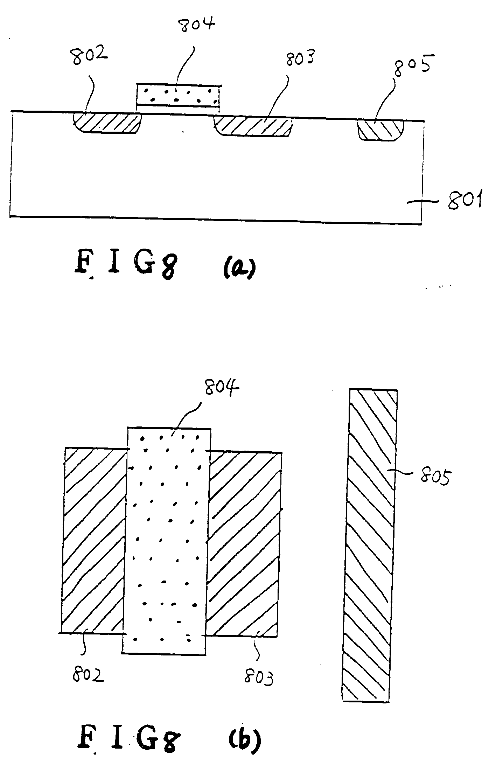

One form of conventional MIS semi-conductor device will be described first with reference to Figures 8 (a) and 8 (b), which are sectional and plan views, respectively, of such a device. As shown, a P-type silicon substrate 801 has N-type diffusion layers, acting as a drain 802 and a source 803, formed in the surface thereof. A gate electrode 804 is formed across the drain 802 and the source 803. A P-type high density diffusion layer 805 (hereinafter referred to as a sub-region) is provided for establishing the potential of the P-type substrate 801. The prior art gives no particular consideration as to the disposition of this P-type high density diffusion layer 805.

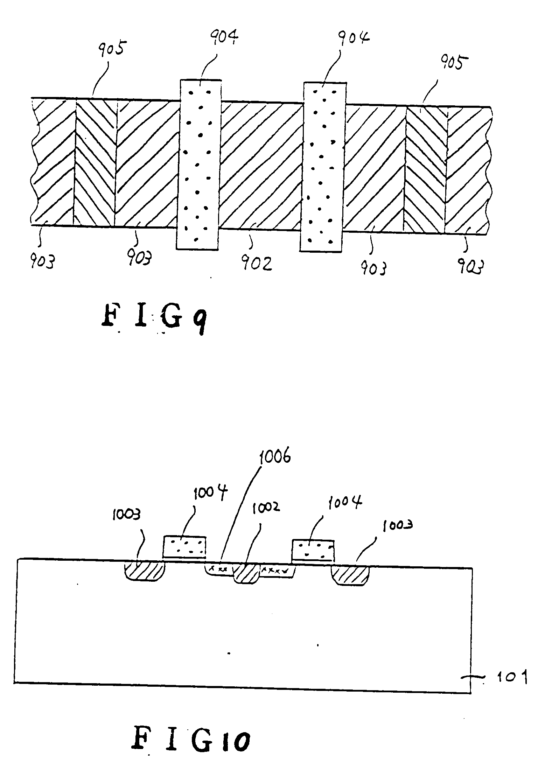

In another conventional semi-conductor device having a plurality of gate electrodes 904 arranged as shown in Figure 9 across source and drain regions 902, 903, P⁺ diffusion layers 905 for establishing the potential of the substrate are formed between N⁺ diffusion layers providing the source regions 903.

With the foregoing transistor configurations, however, if an over load voltage is imposed or if there is a surge of static electricity, there is a tendency for the diffusion layer providing the drain to break down (the initial point of breakdown is the gate edge of the drain) and, successively, for a parasitic bi-polar transistor formed through the drain-substrate-source to turn on, leading to permanent destruction. Such a tendency is particularly severe in the case of N-channel transistors.

A known so called high-withstand-voltage transistor workable even at high voltages is shown in Figure 10 and has a drain composed of a high density diffusion layer 1002 and a low density diffusion layer 1006. This type of transistor also has a strong tendency to be destroyed if exposed to an excess voltage.

DE-A-3 408 285 describes a MOSFET which is protected from an overload voltage applied to the drain (or source). A portion of the drain region remote from the channel is adjacent to a further region having the same conductivity type as the substrate. The pn-junction between the drain and the further region has a breakdown voltage which can be adjusted by implanting impurities into the further region.

The present invention seeks to provide a semi-conductor device which obviates or mitigates the above problems.

According to a first aspect of the invention, there is provided a MIS semiconductor device which includes a drain formed in a surface of a semi-conductor substrate adjacent to a gate electrode; a sub-region formed in the surface of the semiconductor substrate, the sub-region comprising a diffusion layer having the same conductivity type as and a higher impurity density than the substrate; said drain comprising an impurity doped region facing the sub-region, and a low density impurity doped layer, which has a first portion facing the sub-region and a second portion adjacent to the gate electrode, the width of the first portion of the low density impurity doped layer being less than the width of the second portion of the low density impurity doped layer, and said impurity doped region having a lower withstand voltage than said second portion of the low density impurity region.

According to a second aspect of the present invention, there is provided a MIS semi-conductor device which includes a drain (102, 106; 302, 306; 402, 406) formed in a surface of a semi-conductor substrate (101) adjacent to a gate electrode (104;304;404); a sub-region (105; 305; 405) formed in the surface of the semi-conductor substrate, the sub-region comprising a diffusion layer having the same conductivity type as and a higher impurity density than the substrate; said drain comprising an impurity doped region facing the sub-region, a low density impurity doped layer (106), which has a first portion facing the sub-region and a second portion adjacent to the gate electrode, the impurity density of the first portion of the low density impurity doped layer being higher than the impurity density of the second portion of the low density impurity doped layer, and said impurity doped layer having a lower withstand voltage than said second portion of the low density impurity doped layer.

According to a third aspect of the present invention, there is provided a MIS semi-conductor device which includes a drain (102, 106; 302, 306; 402, 406) formed in a surface of a semi-conductor substrate (101) adjacent to a gate electrode (104;304;404); a sub-region (105; 305; 405) formed in the surface of the semi-conductor substrate, the sub-region comprising a first diffusion layer having the same conductivity type as and a higher impurity density than the substrate; said drain comprising an impurity doped region facing the sub-region (105), and a portion (106) adjacent to the gate electrode, said impurity doped region having a lower withstand voltage than a portion of the drain adjacent to the gate electrode, characterised in that the sub-region further comprises a second diffusion layer (701) having the same conductivity type as and a lower impurity density than the first diffusion layer, the second diffusion layer being arranged so as at least partly to adjoin or overlap the part of the drain facing the sub-region.

The invention will be described further, by way of example, with reference to the accompanying drawings, in which:-
Figures 1(a) and 1(b) are a sectional view and a plan view, respectively, showing a main portion of a first example of a MIS semi-conductor device;
Figure 2 is a diagram showing the correlation between the width of an N⁻ layer formed between a drain and a sub-region of the semi-conductor device, the distance between the N⁻ layer and the sub-region, and the withstand voltage between the drain and the sub-region;
Figures 3 and 4 are plan views showing a further semi-conductor device H;
Figures 5, 6 and 7 are sectional views showing modifications according to the invention of the semi-conductor device shown in Figure 1;
Figures 8 (a) and 8 (b) are a sectional view and a plan view, respectively, showing a conventional device; and
Figures 9 and 10 are a plan view and a sectional view, respectively, showing further conventional devices.

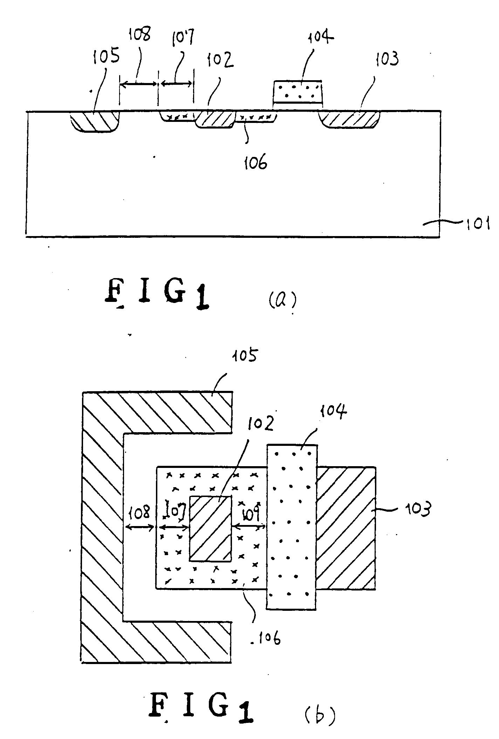

Referring initially to Figures 1 (a) and 1 (b), an MIS semi-conductor device has a P-type silicon substrate 101 having formed in the surface thereof a drain composed of an N-type high density diffusion layer 102 and an N-type low density diffusion layer 106 (hereinafter referred to as an N⁻ layer), which is provided for the purpose of enhancing the withstand voltage characteristics of the device. An N-type high density diffusion layer 103 acting as a source and a gate or channel electrode 104 are also provided. A P-type high density diffusion layer 105 (hereinafter referred to as a sub-region) having a higher impurity density than the substrate is disposed so as to surround a portion of the drain apart from a gate edge thereof. (It should be noted that the sub-region 105 is not necessarily required to cover the side surface of the drain).

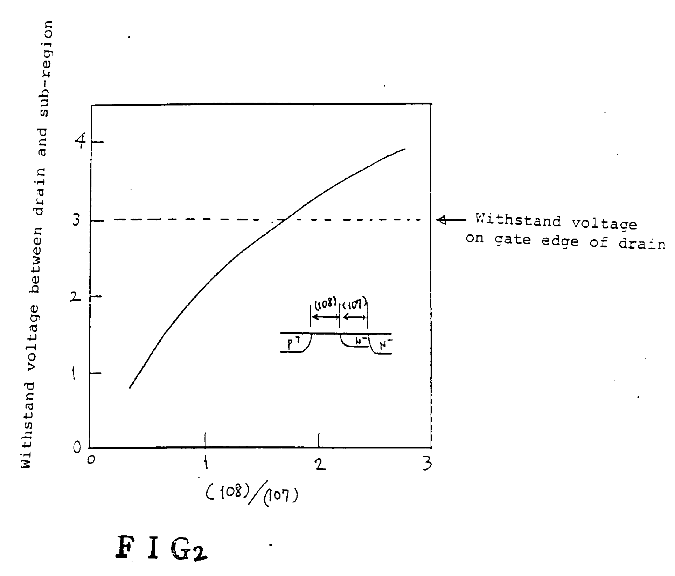

To examine the withstand voltage characteristics of the device, the withstand voltage between the drain and the sub-region 105 is evaluated in dependence upon a parameter which is derived from the distance 108 between the N⁻ layer 106 and the sub-region 105 divided by the width 107 of a portion of the N⁻ layer 106 that confronts the sub-region 105. The results are shown in Figure 2. Here, the value of the parameter, which is the distance 108 divided by the width 107, is set such that the withstand voltage between the drain and the sub-region 105 is lower than the withstand voltage at the gate edge of the drain (i.e. in this embodiment, the parameter is set to be less than 2).

In this way, since the withstand voltage between the drain and the sub-region 105 is less than the withstand voltage at the gate edge of the drain, when excessive voltage or static electricity are imposed, breakdown occurs initially in between the drain and the sub-region 105, and the breakdown current is absorbed efficiently into the sub-region 105 because it is formed from the P⁺ type high density impurity layer. Since such breakdown merely features the breakdown of a diode, permanent destruction is largely avoided. Further, since no breakdown occurs at the gate edge, a parasitic bi-polar transistor as described above in relation to the prior art is not made operational and so the breakdown does not lead to permanent destruction of the transistor.

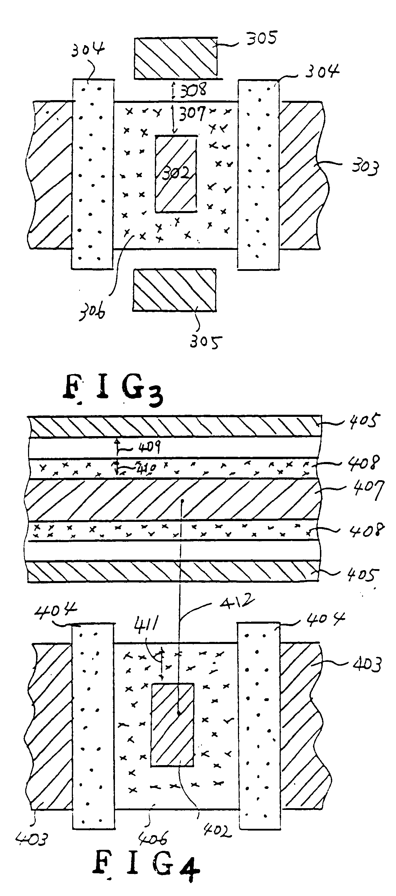

Figure 3 shows a transistor device having two gate electrodes. Although this device includes only two gate electrodes, the same results can be obtained in a device with three or more gate electrodes by repeating the arrangement shown. In this instance, a sub-region 305 confronts a drain N⁻ layer 306 at a side surface of the drain. The relationship between the withstand voltage and the parameter derived from the width 307 and the distance 308 is identical with that obtained from the semi-conductor device of Figure 1. Thus, by appropriately setting the distance 308, it is possible to ensure that the withstand voltage between the drain and the sub-region is lower than the withstand voltage at the gate edge of the drain.

The embodiment shown in Figure 3 sometimes suffers from the drawback that it cannot absorb the breakdown current sufficiently because the drain confronts the sub-region 305 only at its side surface. However, a modification of this embodiment shown in Figure 4 overcomes this problem in that a diode having the same configuration as that of the drain is formed in an area outside the transistor, this diode being connected with the drain and a sub-region being formed which confronts the diode, whereby the breakdown current can be absorbed sufficiently.

More especially, the modification of Figure 4 features a drain high density diffusion layer 402, a diode high density diffusion layer 407, a drain low density diffusion layer 406, a diode low density diffusion layer 408, and a P⁺ diffusion layer 405 providing a sub-region. The withstand voltage of the diode is set to be lower than the withstand voltage at the gate edge of the drain by appropriate selection of the width 410 of the N⁻ layer 408 and the distance 409 between the N⁻ layer 408 and the sub-region 405. Since the drain high density diffusion layer 402 is connected with the diode high density diffusion layer 407 as illustrated by a solid line 412, an excess voltage imposed on the drain is transmitted also to the diode, and thus can be absorbed efficiently by the sub-region. It should be noted that the width 411 of the N⁻ layer 406 at the side surface of the drain may be larger than the width 410 of the diffusion layer 408.

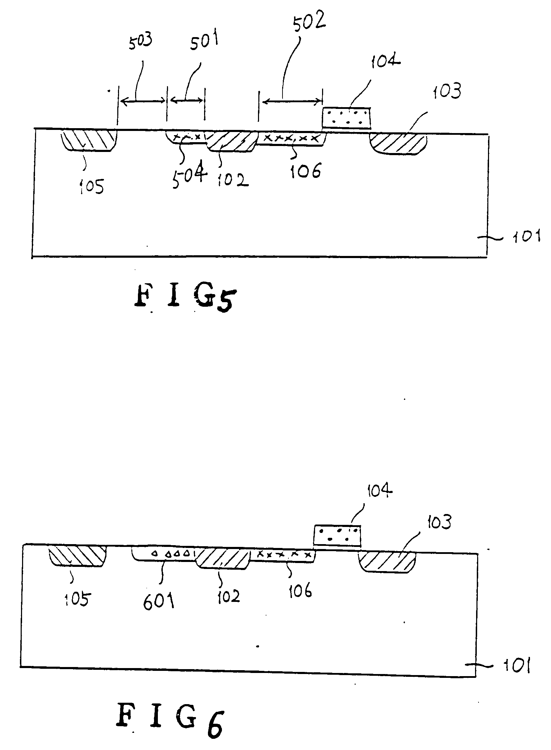

In general, the portion of the N⁻ layer confronting the sub-region is formed so as to have the same width as the portion of the N⁻ layer on the gate or channel side. However, in a modification according to the present invention of the Figure 1 embodiment shown in Figure 5, other possibilities for the width 501 of the N⁻ layer 106 confronting the sub-region 105 and the width 502 of the N⁻ layer on the side of the gate 104 are considered. The layer 106 is an off-set layer as is well known in the art, and so a depletion layer spreads into this layer 106 when a voltage is imposed. This is also true for the portion 504 of the layer 106 confronting the sub-region 105, the depletion layer spreading into the portion 504 being identical in width with that spreading into the remainder of the layer 106. Thus, by making the width 501 of the portion 504 of the N⁻ layer 106 confronting the sub-region 105 smaller than the width 502 of the N⁻ layer 106 on the gate side, it is possible to lower the withstand voltage between the drain and the sub-region below the withstand voltage at the gate edge of the drain. It has been found that by using this method, that is by making the width 501 of the N⁻ layer 106 confronting the sub-region 105 less than the width 502 of the N⁻ layer 106 on the gate side, the same results as above can be obtained even where the distance from the N⁻ layer portion 504 to the sub-region 105 is somewhat long.

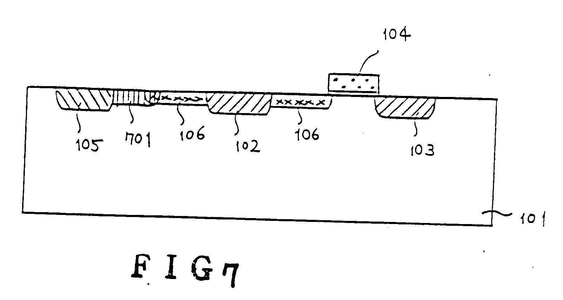

In the modification according to the invention shown in Figure 6, the impurity density of a portion 601 of the drain N⁻ layer 106 confronting the sub-region 105 is made higher than that of the drain N⁻ layer 106 on the gate side for the purpose of lowering the withstand voltage between the drain and the sub-region below the withstand voltage at the gate edge of the drain. Using this method, the same effect as above may be obtained. In a further modification according to the invention shown in Figure 7, a P-type low density diffusion layer 701 is formed contiguous with the sub-region 105 and so as to adjoin or overlap the N⁻ layer 106 confronting the sub-region for the purpose of making the withstand voltage between the drain and the sub-region lower than the withstand voltage at the gate edge of the drain. In this embodiment, it is possible to set the withstand voltage between the drain and the sub-region freely by regulating the impurity density of the layer 701.

As described above, according to the present invention the sub-region is formed in the vicinity of the drain of the transistor, and the withstand voltage between the drain and the sub-region is made lower than the withstand voltage on the gate or channel side of the drain. As a result, there is provided an MIS transistor which need not suffer permanent destruction even if an excess voltage or static electricity is imposed.

## Claims

1. A MIS semi-conductor device which includes a drain (102, 106; 302, 306; 402, 406) formed in a surface of a semi-conductor substrate (101) adjacent to a gate electrode (104;304;404); a sub-region (105; 305; 405) formed in the surface of the semi-conductor substrate, the sub-region comprising a diffusion layer having the same conductivity type as and a higher impurity density than the substrate; said drain comprising an impurity doped region (102) facing the sub-region, and a low density impurity doped layer (106), which has a first portion facing the sub-region (105) and a second portion adjacent to the gate electrode, the width (501) of the first portion of the low density impurity doped layer being less than the width (502) of the second portion of the low density impurity doped layer, and said impurity doped region (102) having a lower withstand voltage than said second portion of the low density impurity doped layer.

2. A MIS semi-conductor device which includes a drain (102, 106; 302, 306; 402, 406) formed in a surface of a semi-conductor substrate (101) adjacent to a gate electrode (104;304;404); a sub-region (105; 305; 405) formed in the surface of the semi-conductor substrate, the sub-region comprising a diffusion layer having the same conductivity type as and a higher impurity density than the substrate; said drain comprising an impurity doped region (102) facing the sub-region, and a low density impurity doped layer (106), which has a first portion facing the sub-region (105) and a second portion adjacent to the gate electrode, the impurity density of the first portion of the low density impurity doped layer being higher than the impurity density of the second portion of the low density impurity doped layer, and said impurity doped region having a lower withstand voltage than said second portion of the low density impurity doped layer.

3. A MIS semi-conductor device which includes a drain (102, 106; 302, 306; 402, 406) formed in a surface of a semi-conductor substrate (101) adjacent to a gate electrode (104;304;404); a sub-region (105; 305; 405) formed in the surface of the semi-conductor substrate, the sub-region comprising a first diffusion layer (105) having the same conductivity type as and a higher impurity density than the substrate; said drain comprising an impurity doped region (102) facing the sub-region (105), and a portion (106) adjacent to the gate electrode, said impurity doped region having a lower withstand voltage than said portion of the drain adjacent to the gate electrode, characterised in that the sub-region further comprises a second diffusion layer (701) having the same conductivity type as and a lower impurity density than the first diffusion layer (105), the second diffusion layer (701) being arranged so as at least partly to adjoin or overlap the part of the drain (106) facing the sub-region.

## Patentansprüche

1. MIS-Halbleiterbauteil, umfassend ein Drain (102, 106; 302, 306; 402; 406), welches in einer Oberfläche eines Halbleitersubstrats (101) benachbart einer Gate-Elektrode (104; 304; 404) gebildet ist; einen Unterbereich (105; 305; 405), welcher in der Oberfläche des Halbleitersubstrats gebildet ist, wobei der Unterbereich eine Diffusionsschicht des gleichen Leitungstyps wie und mit einer höheren Fremdstoffdichte als das Substrat umfaßt, wobei das Drain einen fremdstoffdotierten Bereich (102) umfaßt, welcher dem Unterbereich gegenüberliegt, sowie eine mit geringer Fremdstoffdichte dotierte Schicht (106), welche einen ersten dem Unterbereich (105) gegenüberliegenden Abschnitt sowie einen zweiten der Gate-Elektrode benachbarten Abschnitt aufweist, wobei die Breite (501) des ersten Abschnitts der mit geringer Fremdstoffdichte dotierten Schicht kleiner ist als die Breite (502) des zweiten Abschnitts der mit geringer Fremdstoffdichte dotierten Schicht, und wobei der fremdstoffdotierte Bereich (102) eine geringere Spannungsfestigkeit aufweist als der zweite Abschnitt der mit geringer Fremdstoffdichte dotierten Schicht.

2. MIS-Halbleiterbauteil umfassend ein Drain (102, 106; 302, 306; 402; 406), welches in einer Oberfläche eines Halbleitersubstrats (101) benachbart einer Gate-Elektrode (104; 304; 404) gebildet ist; einen Unterbereich (105; 305; 405), welcher in der Oberfläche des Halbleitersubstrats gebildet ist, wobei der Unterbereich eine Diffusionsschicht des gleichen Leitungstyps wie und mit einer höheren Fremdstoffdichte als das Substrat umfaßt, wobei das Drain einen fremdstoffdotierten Bereich (102) umfaßt, welcher dem Unterbereich gegenüberliegt, sowie eine mit geringer Fremdstoffdichte dotierte Schicht (106), welche einen ersten dem Unterbereich (105) gegenüberliegenden Abschnitt sowie einen zweiten der Gate-Elektrode benachbarten Abschnitt aufweist, wobei die Fremdstoffdichte des ersten Abschnitts der mit geringer Fremdstoffdichte dotierten Schicht höher ist als die Fremdstoffdichte des zweiten Abschnitts der mit geringer Fremdstoffdichte dotierten Schicht, und wobei der fremdstoffdotierte Bereich eine geringere Spannungsfestigkeit aufweist als der zweite Abschnitt der mit geringer Fremdstoffdichte dotierten Schicht.

3. MIS-Halbleiterbauteil umfassend ein Drain (102, 106; 302, 306; 402; 406), welches in einer Oberfläche eines Halbleitersubstrats (101) benachbart einer Gate-Elektrode (104; 304; 404) gebildet ist; einen Unterbereich (105; 305; 405), welcher in der Oberfläche des Halbleitersubstrats gebildet ist, wobei der Unterbereich eine erste Diffusionsschicht (105) des gleichen Leitungstyps wie und mit einer höheren Fremdstoffdichte als das Substrat umfaßt, wobei das Drain einen fremdstoffdotierten Bereich (102) umfaßt, welcher dem Unterbereich (105) gegenüberliegt, sowie einen Abschnitt (106), welcher der Gate-Elektrode benachbart ist, wobei der fremdstoffdotierte Bereich eine geringere Spannungsfestigkeit als der der Gate-Elektrode benachbarte Abschnitt des Drains aufweist, dadurch gekennzeichnet, daß der Unterbereich ferner eine zweite Diffusionsschicht (701) des gleichen Leitungstyps wie und mit einer geringeren Fremdstoffdichte als die erste Diffusionsschicht (105) umfaßt, wobei die zweite Diffusionsschicht (701) derart angeordnet ist, daß sie wenigstens teilweise an den dem Unterbereich gegenüberliegenden Teil des Drains (106) angrenzt oder diesen überlappt.

## Revendications

1. Dispositif semi-conducteur MIS qui comprend un drain (102,106;302,306;402,406) formé dans une surface d'un substrat semi-conducteur (101) adjacent à une électrode de grille (104;304;404) ; une sous-région (105;305;405) formée dans la surface du substrat semi-conducteur, la sous-région comprenant une couche obtenue par diffusion ayant le même type de conductivité et une densité d'impuretés plus élevée que le substrat ; ledit drain comprenant une région (102) dopée d'impuretés en face de la sous-région, et une couche dopée d'impuretés de basse densité (106), qui a une première partie en face de la sous-région (105) et une seconde partie adjacente à l'électrode de grille, la largeur (501) de la première partie de la couche dopée d'impuretés de basse densité étant inférieure à la largeur (502) de la seconde partie de la couche dopée d'impuretés de basse densité, et ladite région (102) dopée d'impuretés ayant une tension de maintien plus basse que ladite seconde partie de la couche dopée d'impuretés de basse densité.

2. Dispositif semi-conducteur MIS qui comprend un drain (102,106;302,306;402,406) formé dans une surface d'un substrat semi-conducteur (101) adjacent à une électrode de grille (104;304;404); une sous-région (105;305;405) formée dans la surface du substrat semi-conducteur, la sous-région comprenant une couche obtenue par diffusion ayant le même type de conductivité et une densité d'impuretés plus élevée que le substrat ; ledit drain comprenant une région dopée d'impuretés (102) en face de la sous-région et une couche dopée d'impuretés de basse densité (106), qui a une première partie en face de la sous-région (105) et une seconde partie adjacente à l'électrode de grille, la densité d'impuretés de la première partie de la couche dopée d'impuretés de basse densité étant plus élevée que la densité d'impuretés de la seconde partie de la couche dopée d'impuretés de basse densité, et ladite région dopée d'impuretés ayant une tension de maintien plus basse que ladite seconde partie de la couche dopée d'impuretés de basse densité.

3. Dispositif semi-conducteur MIS qui comprend un drain (102,106;302,306;402,406) formé dans une surface d'un substrat semi-conducteur (101) adjacent à une électrode de grille (104;304;404); une sous-région (105;305;405) formée dans la surface du substrat semi-conducteur, la sous-région comprenant une première couche obtenue par diffusion (105) ayant le même type de conductivité et une densité d'impuretés plus élevée que le substrat; ledit drain comprenant une région dopée d'impuretés (102) en face de la sous-région (105), et une partie (106) adjacente à l'électrode de grille, ladite région dopée d'impuretés ayant un voltage de maintien plus bas que ladite partie du drain adjacente à l'électrode de grille, caractérisé en ce que la sous-région comprend de plus une seconde couche obtenue par diffusion (701) ayant le même type de conductivité et une densité d'impuretés plus basse que la première couche obtenue par diffusion (105), la seconde couche obtenue par diffusion (701) étant disposée de telle manière à être au moins partiellement jointive ou à chevaucher le drain(106) en face de la sous-région.
